**Europäisches Patentamt**

**European Patent Office**

**Office européen des brevets**

(11) Veröffentlichungsnummer: **0 502 300 A1**

## (12) EUROPÄISCHE PATENTANMELDUNG

(21) Anmeldenummer: **92101117.7**

(22) Anmeldetag: **24.01.92**

(51) Int. Cl.⁵: **H05K 1/14**, H05K 3/36, H05K 7/14, F16B 5/06

(30) Priorität: **05.03.91 CH 660/91**

(43) Veröffentlichungstag der Anmeldung:
**09.09.92 Patentblatt 92/37**

(84) Benannte Vertragsstaaten:
**AT BE DE DK ES FR GB GR IT LU NL SE**

(71) Anmelder: **Elektro-Apparatebau Olten AG**
**Tannwaldstrasse 88**
**CH-4600 Olten(CH)**

(72) Erfinder: **Roza, Ivan**
**Reiserstrasse 35**
**CH-4600 Olten(CH)**

(74) Vertreter: **Fillinger, Peter, Dr.**
**Rütistrasse 1a, Postfach 358**
**CH-5401 Baden(CH)**

### (54) Distanzgeber.

(57) Der Distanzgeber dient der Distanzhaltung und Verbindung von zwei parallel hintereinander anzuordnenden Platten (1, 2), insbesondere zur gleichmässigen Distanzvorgabe zwischen der Frontplatte (1) einer Schalttafel und einer rückseitigen, parallelen Printplatte (2). Er besteht aus einem Sockel (3) und einem in oder über diesen schiebbaren Steckteil (12). Der Sockel (3) weist konzentrisch um seine Mittelachse (6) mindestens vier gegen den Steckteil (12) offene Führungen (8) auf, deren Tiefe (T) durch Anschlagflächen (10) begrenzt ist. Diese Führungen (8) bilden Gruppen unterschiedlicher Tiefe (T), die radialsymmet- risch zur Mittelachse (6) liegen, wogegen der Steckteil (12) auf der dem Sockel (3) zugewandten Seite Vorsprünge (14) aufweist, die bei entsprechender Drehlage in die Führungen (8) einer Gruppe schiebbar sind.

Fig. 1

Die vorliegende Erfindung bezieht sich auf einen Distanzgeber für zwei parallel hintereinander anzuordnende Platten gemäss dem Oberbegriff des Anspruchs 1.

Mit Abstand hinter der Frontplatte einer Schalttafel ist bei deren Zusammenbau oft eine Printplatte planparallel zu befestigen. Zu diesem Zweck werden Distanzstifte mit Gewindebohrungen in den endseitigen Stirnflächen verwendet. Diese Distanzstifte werden rechtwinklig zwischen Front- und Printplatte gestellt und danach mittels durch die Platten hindurchgeführten Schrauben miteinander verschraubt oder an der Frontplatte angeschweisst. Das Anbringen der Bohrlöcher in den Platten für die Befestigungsschrauben erfordert eine hohe Genauigkeit und ist nur mittels Bohrlehren möglich. Zudem ist der Zusammenbau der beiden Platten und der Distanzgeber zeitaufwendig. Ein weiterer Nachteil besteht darin, dass für jeden gewünschten Plattenabstand Distanzgeber entsprechender Länge an Lager zu halten sind. Sind die Distanzstifte an der Frontplatte angeschweisst, ist an dieser eine neue Oberflächenbehandlung notwendig.

Die vorliegende Erfindung will einen Distanzgeber der erwähnten Art derart gestalten, dass mit einer einzigen Ausführungsform mehrere unterschiedliche Plattenabstände erreicht werden können. Erfindungsgemäss wird diese Aufgabe gelöst durch die kennzeichnenden Merkmale des Anspruchs 1.

Werden bei einem erfindungsgemässen Distanzgeber auf der Oberseite des Sockels bei den einzelnen Führungen Symbole entsprechend deren Tiefe angebracht, sind sie gleichzeitig eine Angabe für die Höhe des Distanzgebers und es brauchen lediglich die Vorsprünge des Steckteils in die zutreffenden Führungen geschoben zu werden, damit sich der Distanzgeber von selbst auf den gewünschten Plattenabstand einstellt.

Damit die aufwendige Zentrier- und Montagearbeit beim Zusammenbau einer Schalttafel weiter gekürzt werden kann, wird im vorliegenden Patent ein Distanzgeber gemäss dem Anspruch 4 vorgeschlagen. Die Vereinfachung der Montage ist dabei am weitestgehenden bei einer Ausführungsform gemäss den Ansprüchen 1, 4 und 8 erreicht. Bei Verwendung solcher Distanzgeber wird zuerst der Sockel an der Printplatte festgeschraubt und danach in diesem das Steckteil mit der gewünschten Distanzvorgabe eingerastet. Sind mehrere Distanzgeber auf diese Weise an der Printplatte befestigt, wird die Schutzfolie von deren Selbstklebeschicht entfernt und anschliessend die Frontplatte mit den Distanzgebern zur Anlage gebracht, wobei sie auf deren Stützkörper zu liegen kommt. Auf diesen gleitend kann nun die Printplatte relativ zur Frontplatte mit nur geringer Haftreibung in die gewünschte Lage verschoben (zentriert) werden. Befindet sie sich in der gewünschten Stellung, wird sie gegen die Frontplatte gedrückt. Unter diesem Druck biegen sich (unter bleibender Verformung) die Stützkörper nach aussen, bis die Frontplatte die Selbstklebeschicht berührt und fest an ihr haftet. Eine weitere Verbindung zwischen Front- und Printplatte entfällt.

Anhand der beiliegenden schematischen Zeichnung wird die Erfindung beispielsweise erläutert. Es zeigen:

Fig. 1    einen Querschnitt durch eine Schalttafel entsprechend der Linie I-I in Fig. 1 und

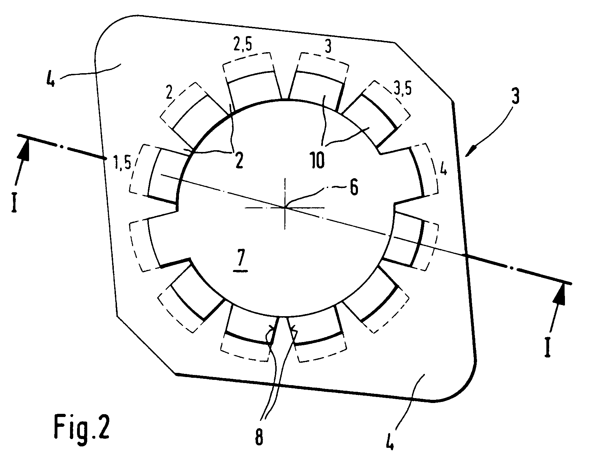

Fig. 2    eine Ansicht eines Distanzgebersockels in Richtung des Pfeiles II in Fig. 1.

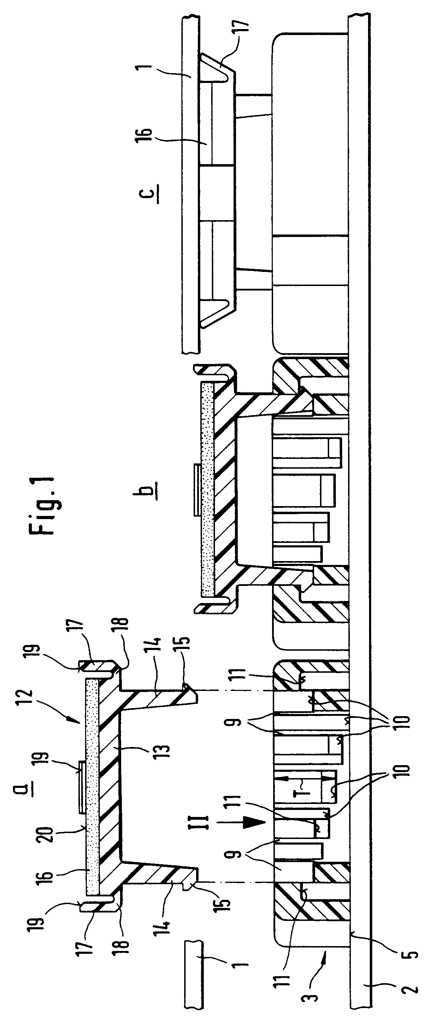

In der Zeichnung bezeichnen die Hinweisziffern 1 und 2 die Front- und die Printplatte einer Schalttafel. Die Front- und die Printplatte 1 und 2 sind durch mehrere Distanzgeber beabstandet und miteinander verbunden, wobei die Fig. 1 den gleichen Distanzgeber in drei verschiedenen Montagephasen a, b und c darstellt. Der Distanzgeber weist einen an der Printplatte 2 befestigten Sockel 3 auf, der zu gegenüberliegenden Seiten zwei Befestigungslappen 4 bildet, durch die Befestigungsschrauben in die Printplatte 2 geschraubt sind. Der Sockel 3 berührt die Printplatte 2 mit einer ebenen, zu seiner Mittelachse 6 rechtwinkligen Anlagefläche 5 und weist eine zu seiner Mittelachse 6 achsiale, im Querschnitt kreisrunde Durchbrechung 7 auf. An die Durchbrechung 7 grenzen achsparallele Führungen 8, die durch Wände 9 voneinander getrennt sind. Die Tiefe T jeder Führung 8 wird durch eine Anschlagfläche 10 begrenzt bzw. bestimmt, wie dies später noch erläutert wird.

Die Führungen 8 sind radial symmetrisch und in gerader Zahl um die Mittelachse 6 des Sockels 3 angeordnet, wobei jeweils zwei sich diametral (also punktsymmetrisch) gegenüberliegende Führungen 8 die gleiche Tiefe T haben und in der Terminologie des Patentes zusammen eine Gruppe bilden. Im gezeigten Beispiel sind die sechs Gruppen. Auf der Sockeloberseite ist jede Gruppe durch eine die Tiefe T der Führungen 8 charakterisierende Zahl bezeichnet, die gleichzeitig auf die Höhe des zusammengesetzten Distanzgebers verweist. Aus den angegebenen Zahlen ist ersichtlich, dass die Tiefe der Führungen 8 von Gruppe zu Gruppe verschieden und um den gleichen Betrag gestuft ist. Jeder der Führungen 8 ist zudem eine hinterschnittene Schulter 11 zugeordnet, die Teil einer Rastverbindung mit einem nachfolgend beschriebenen Steckteil 12 ist.

Das zum Sockel 3 komplementäre Steckteil 12 ist mit zwei von einer Platte 13 nach hinten ragenden Vorsprüngen 14 versehen, von denen jeder eine nach aussen weisende Rastnase 15 hat. Wird der Steckteil 12 in den Sockel 3 gesteckt, gleiten die sich diametral gegenüberliegenden Vorsprünge 14 mit ihren Rastnasen 15 auf den Grund von zwei sich gegenüberliegenden (eine Gruppe bildenden) Führungen 8 nach unten, wobei sie federnd eingebogen sind. Mit dem Auftreffen der Vorsprünge 14 auf die Anschlagflächen 10 überschreiten die Rastnasen 15 die Schulter 11 und verrasten mit ihr. Das Steckteil 12 ist nun unverlierbar und spielfrei am Sockel 3 gehalten. Je nach der Drehlage des Steckteils 12 befinden sich die Vorsprünge 14 in Führungen 8 einer Gruppe mit der Bezeichnung 1.5, 2, 2.5, 3, 3.5 oder 4 und die Höhe des Distanzgebers ist entsprechend festgelegt.

Auf ihrer Oberseite ist die Platte 13 des Steckteils 12 mit einer von einer Schutzfolie abgedeckten Selbstklebeschicht 16 versehen. Diese bildet eine zweite Anlagefläche 20, die mit der Rückseite der Frontplatte in Berührung zu stehen hat. Über die Selbstklebeschicht 16 ragen vier radial symmetrisch angeordnete Stützkörper 17, welche mit ihren freien Enden die Selbstklebeschicht 16 geringfügig überragen. Sie sind einstückig mit der Platte 13 gefertigt und mit dieser durch eine Biegeverbindung 18 verbunden. An ihren oberen freien Enden weisen sie eine gegen die Selbstklebeschicht 16 geneigte Schrägfläche 19 auf.

Ist, wie die Fig. 1 für die Montagephase b zeigt, das Steckteil 12 im Sockel 3 befestigt, können Frontplatte 1 und Stützkörper 17 gegeneinander gelegt werden. Liegt die Printplatte auf der Frontplatte, ist die Belastung so gering, dass im Bereich der Biegeverbindung 18 praktisch keine Verformung der Stützkörper 17 eintrifft. In dieser Lage der Stützkörper 17 ist die Frontplatte 1 darauf leicht verschiebbar. Die Frontplatte 1 wird nun auf den Stützkörpern 17 so lange verschoben, bis sie genau die ihr zugedachte Lage einnimmt. In dieser Lage wird die Frontplatte 1 gegen die Printplatte 2 gedrückt, wodurch sich die Stützkörper 17 (begünstigt durch die Schrägflächen 19) nach aussen biegen (Fig. 1c). Ist die Schutzfolie von der Selbstklebeschicht entfernt, haftet die Frontplatte 1 an der Selbstklebeschicht 16. Deren Haftkraft ist so gross, dass in den Stützkörpern 17 (namentlich im Bereich der Biegeverbindung 18 allfällig noch vorhandene elastische Rückstellkräfte praktisch vernachlässigbar sind. Sobald die Frontplatte 1 an der Selbstklebeschicht 16 haftet ist sie nicht nur mit der Printplatte 2 fest verbunden sondern auch mit Bezug auf diese genau parallel und im gewünschten durch die Stecklage des Steckteils 12 bestimmten Abstand entsprechend der Höhe des Distanzgebers gehalten.

Nach einem nicht dargestellten Ausführungsbeispiel ist es auch möglich, die zu einer Gruppe gehörenden Führungen 8 nicht punktsymmetrisch sondern radialsymmetrisch um die Achse 6 anzuordnen, wobei eine Gruppe drei oder vier Führungen umfassen kann. In diesem Fall wären am Steckteil drei oder vier Vorsprünge 14 radial symmetrisch anzuordnen. Weiter ist es möglich, dem Sockel 3 eine rotationssymmetrische Umfangslinie zu geben und die Führungen 8 auf dessen Aussenseite anzuordnen.

**Patentansprüche**

1. Distanzgeber für zwei parallel hintereinander anzuordnende Platten (1, 2), insbesondere zur gleichmässigen Distanzvorgabe zwischen der Frontplatte (1) einer Schalttafel und einer rückseitigen, parallelen Printplatte (2), dadurch gekennzeichnet, dass ein Sockel (3) mit einer ersten Anlagefläche (5) für eine erste Platte (2) sowie ein in oder über diesen schiebbaren Steckteil (12) vorhanden ist, welchem Steckteil (12) auf der dem Sockel (3) abgewandten Seite eine zur ersten Anlagefläche (5) parallele, zweite Anlagefläche (20) für eine zweite Platte (1) zugeordnet ist, dass der Sockel (3) konzentrisch um seine zu den Anlageflächen (5, 20) rechtwinklige Mittelachse (6) mindestens vier gegen den Steckteil (12) offene Führungen (8) aufweist, deren Tiefe (T) durch Anschlagflächen (10) begrenzt ist, dass diese Führungen (8) Gruppen unterschiedlicher Tiefe (T) bilden, die radialsymmetrisch zur Mittelachse (6) liegen, und dass der Steckteil (12) auf der dem Sockel (3) zugewandten Seite Vorsprünge (14) aufweist, die bei entsprechender Drehlage in die Führungen (8) einer Gruppe schiebbar sind.

2. Distanzgeber nach Anspruch 1, dadurch gekennzeichnet, dass die Vorsprünge (14) bei Anlage mit den Anschlagflächen (10) mit dem Sockel (3) verrasten.

3. Distanzgeber nach Anspruch 1 oder 2, dadurch gekennzeichnet, dass die Tiefe (T) der Führungen (8) zwischen den Gruppen gleichmässig abgestuft ist.

4. Distanzgeber, vorzugsweise nach einem der Ansprüche 1 bis 3, für zwei parallel hintereinander anzuordnende Platten (1, 2), insbesondere zur gleichmässigen Distanzvorgabe zwischen der Frontplatte (1) einer Schalttafel und einer rückseitigen, parallelen Printplatte (2), der eine erste und eine zweite Anlagefläche (5, 20) für eine erste bzw. zweite Platte (1, 2) aufweist, welche Anlageflächen (5, 20) rechtwinklig zur Mittelachse (6) des Distanzgebers orientiert sind, dadurch gekennzeichnet, dass die zweite Anlagefläche (20) durch eine Klebstoffschicht (16) gebildet und im Bereich ihres Randes durch das freie Ende von Stützkörpern (17) gleichmässig überragt ist und dass die Stützkörper (17) durch einen biegbaren Abschnitt (18) mit dem Distanzgeber verbunden sind.

5. Distanzgeber nach Anspruch 4, dadurch gekennzeichnet, dass die Stützkörper (17) am freien Ende eine gegen die Anlagefläche (20) geneigte Fläche (19) aufweisen.

6. Distanzgeber nach Anspruch 4 oder 5, dadurch gekennzeichnet, dass die Klebstoffschicht (16) durch eine Selbstklebefolie gebildet ist.

7. Distanzgeber nach einem der Ansprüche 4 bis 6, dadurch gekennzeichnet, dass die Stützkörper (17) radial symmetrisch um die Mittelachse (6) angeordnet sind.

8. Distanzgeber nach Anspruch 1 oder 4, dadurch gekennzeichnet, dass der Sockel (3) Befestigungsstellen (4) für eine form- und/oder kraftschlüssige Befestigung an der ersten Platte (2) aufweist.

# Fig.1

Fig.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | US-A-3 812 381 (JAMES H. GUYTON) --- | | H05K1/14 H05K3/36 |
| A | DE-A-3 539 361 (SIEMENS AG) ----- | | H05K7/14 F16B5/06 |

|  |  |
|---|---|
|  | **RECHERCHIERTE SACHGEBIETE (Int. Cl.5 )** |
|  | H05K H01R F16B |

Der vorliegende Recherchenbericht wurde für alle Patentansprüche erstellt

| Recherchenort | Abschlußdatum der Recherche | Prüfer |
|---|---|---|
| DEN HAAG | 10 JUNI 1992 | GOOSSENS A. |